(19) Europäisches Patentamt
European Patent Office
Office européen des brevets

(11) EP 1 572 856 B1

(12) EUROPEAN PATENT SPECIFICATION

(45) Date of publication and mention of the grant of the patent:
**13.02.2008 Bulletin 2008/07**

(21) Application number: **03778777.7**

(22) Date of filing: **10.12.2003**

(51) Int Cl.:
*C11D 11/00* (2006.01) *C11D 1/722* (2006.01)
*C11D 3/30* (2006.01) *H01L 21/302* (2006.01)
*H01L 21/306* (2006.01)

(86) International application number:
**PCT/JP2003/015792**

(87) International publication number:
**WO 2004/053045 (24.06.2004 Gazette 2004/26)**

# (54) CLEANING AGENT COMPOSITION, CLEANING AND PRODUCTION METHODS FOR SEMICONDUCTOR WAFER

REINIGUNGSMITTEL, REINIGUNGS- UND HERSTELLUNGSVERFAHREN FÜR HALBLEITERSCHEIBEN

COMPOSITION D'AGENT DE NETTOYAGE, PROCEDES DE NETTOYAGE ET DE PRODUCTION DE PLAQUETTES SEMI-CONDUCTRICES

(84) Designated Contracting States:
**AT BE BG CH CY CZ DE DK EE ES FI FR GB GR HU IE IT LI LU MC NL PT RO SE SI SK TR**

(30) Priority: **12.12.2002 JP 2002361149**

(43) Date of publication of application:
**14.09.2005 Bulletin 2005/37**

(73) Proprietor: **Showa Denko K.K.**
**Tokyo 105-8518 (JP)**

(72) Inventors:
- **AMEMIYA, Masahiro,**
**c/o Showa Denko K.K.**
**Shunan-shi,**
**Yamaguchi 746-0006 (JP)**
- **TANAKA, Yoshio,**
**c/o Showa Denko K.K.**
**Kawanuma-gun,**
**Fukushima 969-3431 (JP)**

(74) Representative: **Strehl, Peter et al**
**Strehl Schübel-Hopf & Partner**
**Maximilianstrasse 54**
**80538 München (DE)**

(56) References cited:
**DE-A- 19 853 961**
**US-A1- 2001 025 017**
**US-A1- 2002 016 272**
**US-A1- 2002 022 582**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

TECHNICAL FIELD

The present invention relates to a cleaning agent composition suitable for the cleaning of a semiconductor wafer such as silicon, gallium-arsenic, gallium-phosphorus and indium-phosphorus, the cleaning of electronics-related various glass substrates such as liquid crystal display glass substrate, solar cell glass substrate and crystal substrate, and the cleaning of a glass or ceramic-made precision work member requiring high cleanliness, such as lens for optical glasses, prism, optical fiber, quartz oscillator and polishing plate for semiconductor wafers. The present invention also relates to methods for cleaning or producing a semiconductor wafer by using the composition.

BACKGROUND ART

Semiconductor devices such as transistor, diode, IC, LSI and rectifying element are produced by applying steps such as vapor growth, formation of oxide film, diffusion of impurities and vapor deposition of electrode metal film, to a silicon wafer or a compound semiconductor wafer such as gallium-arsenic, gallium-phosphorus and indium-phosphorus.

The electric characteristics of a semiconductor device are greatly affected by impurities and therefore, the semiconductor wafer surface is thoroughly cleaned to remove the contamination with impurities before applying respective steps described above. As industrial means therefor, a large number of methods using a treating solution mainly comprising an organic alkali or using a treating solution obtained by adding a complexing agent, a surfactant, an aqueous hydrogen peroxide and the like to an organic alkali have been proposed (see, for example, JP-A-50-147287 (the term "JP-A" as used herein means an "unexamined published Japanese patent application"), Japanese Patent No. 2579401 and JP-A-2001-214199.

For example, JP-A-50-147287 discloses that the sole use of an aqueous solution of, for example, trimethylhydroxyethylammonium hydroxide (choline) or tetramethylammonium hydroxide (hereinafter sometimes referred to as "TMAH") out of tetraalkylammonium hydroxides is effective in the degreasing, removal of contamination with inorganic substances and removal of ultra-thin oxide layer.

However, (1) due to poor wettability to the surface to be treated, the cleaning power is not sufficiently high, and (2) due to etching dependency on the orientation of silicon crystal such that the (100) plane is readily etched and the (111) plane is resistant against etching activity, in the case of a (100) mirror face wafer, this plane is roughened by etching. Thus, problems still remain.

In order to solve these problems, a system where a complexing agent and a hydrogen peroxide are added to an aqueous tetraalkylammonium hydroxide solution is proposed.

However, the cleaning power is not satisfied depending on the purpose or when hydrogen peroxide and an aqueous alkali solution such as tetraalkylammonium hydroxide are used in combination, the hydrogen peroxide decomposes in a short time and therefore, various cumbersome operations are necessary for keeping constant the concentration.

Japanese Patent No. 2579401 describes an aqueous organic alkali solution comprising a tetraalkylammonium hydroxide, an alkanolamine and a nonionic surfactant, and discloses that by using the surfactant, the cleaning power is enhanced and the etching of the silicon crystal (100) plane can be suppressed.

However, the effect of preventing the etching is not sufficiently high and the performance of removing particles is also not satisfied.

JP-A-2001-214199 describes a cleaning solution comprising a hydroxide, water, a water-soluble organic compound and a specific nonionic surfactant.

However, this cleaning solution is not sufficiently high in the activity of removing contamination with oils and fats, though the activity of preventing etching on the silicon crystal (100) plane is enhanced.

Furthermore, due to low solubility of the specific nonionic surfactant in an aqueous alkali solution, a water-soluble organic compound such as isopropyl alcohol must be added so as to elevate the solubility.

With recent progress of highly integrated semiconductors, the level of performance required of the cleaning solution is more and more elevating. Under these circumstances, a new cleaning solution improved in the performance of removing surface contamination of a material to be cleaned and in the effect of preventing etching is being demanded.

DISCLOSURE OF INVENTION

An object of the present invention is to provide a cleaning agent composition having an excellent cleaning power against surface contamination of, for example, a semiconductor wafer, various glass substrates and a glass- or ceramic-made precision work member required to have high cleanliness, exhibiting excellent performance in both the degreasing and the removal of particles on the wafer surface at the cleaning of a semiconductor wafer, and enabling

satisfactory control in the etching of a wafer.

Another object of the present invention is to provide a method for cleaning a semiconductor wafer, where an excellent cleaning power is exhibited against the surface contamination of a semiconductor wafer and the etching of the wafer is satisfactorily controlled.

Still another object of the present invention is to provide a production method for obtaining a semiconductor wafer extremely reduced in particles attached to the semiconductor wafer surface and extremely reduced in the surface roughness.

As a result of extensive investigations to solve those problems, the present inventors have found that the above-described objects can be attained by using a cleaning agent composition comprising a specific nonionic surfactant, a quaternary ammonium hydroxide, and an alkanolamine. The present invention has been accomplished based on this finding.

That is, the present invention is summarized as follows.

[1] A cleaning agent composition comprising a nonionic surfactant represented by the following formula (I):

$$R^1O(EO)_x(PO)_yH \qquad (I)$$

(wherein $R^1$ represents a linear or branched alkyl group having from 6 to 20 carbon atoms or a linear or branched alkenyl group having from 6 to 20 carbon atoms, EO represents an oxyethylene group, PO represents an oxypropylene group, EO and PO each is bonded by random addition or block addition, x number of EOs and y number of POs are arranged in an arbitrary order, x and y each independently represents an integer of 1 to 20, and x/(x+y) is 0.5 or more), a quaternary ammonium hydroxide, and an alkanolamine.

[2] The cleaning agent composition as described in [1] above, wherein the quaternary ammonium hydroxide is a compound represented by the following formula (II):

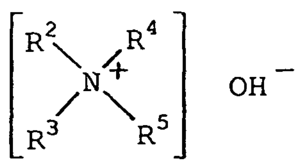

(II)

(wherein $R^2$, $R^3$, $R^4$ and $R^5$ each independently represents an alkyl group having from 1 to 6 carbon atoms or a hydroxyalkyl group having from 1 to 6 carbon atoms).

[3] The cleaning agent composition as described in [2] above, wherein the quaternary ammonium hydroxide is tetramethylammonium hydroxide.

[4] The cleaning agent composition as described in [1] above, wherein the alkanolamine is a compound represented by the following formula (III):

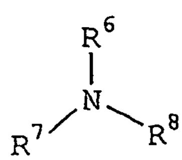

(III)

(wherein $R^6$ represents a hydroxyalkyl group having from 1 to 4 carbon atoms; and $R^7$ and $R^8$ each independently represents a hydrogen atom, an alkyl group having from 1 to 4 carbon atoms, a hydroxyalkyl group having from 1 to 4 carbon atoms or an aminoalkyl group having from 1 to 4 carbon atoms, or $R^7$ and $R^8$ combine to form an alkylene group having from 3 to 6 carbon atoms, and the alkylene group may have an oxygen or nitrogen atom inserted between carbon atoms constituting the main chain).

[5] The cleaning agent composition as described in [4] above, wherein the alkanolamine is any one compound selected from the group consisting of monoethanolamine, diethanolamine and triethanolamine.

[6] The cleaning agent composition as described in [1] above, wherein the alkanolamine is contained in an amount of 0.001 to 50 mass% based on the entire amount of the cleaning agent composition.

[7] The cleaning agent composition as described in [1] above, wherein the nonionic surfactant is contained in an amount of 0.0001 to 10 mass% based on the entire amount of the cleaning agent composition.

[8] The cleaning agent composition as described in [7] above, wherein the quaternary ammonium hydroxide is contained in an amount of 0.001 to 30 mass% based on the entire amount of the cleaning agent composition.
[9] A method for cleaning a semiconductor wafer, comprising the steps of:

(i) cleaning the wafer using the cleaning agent composition described in any one of [1] to [8] above; and
(ii) cleaning the wafer using a composition containing ammonia and hydrogen peroxide.

[10] The method for cleaning a semiconductor wafer as described in [9] above, wherein the degreasing and removal of particles on the semiconductor wafer surface are performed in the step (i).
[11] The method for cleaning a semiconductor wafer as described in [10] above, wherein the removal of particles on the semiconductor wafer surface are performed in the step (ii).
[12] A method for producing a semiconductor wafer, comprising the steps of:

lapping the wafer surface;
specularly polishing the wafer surface;
cleaning the wafer using the cleaning agent composition described in any one of [1] to [8] above; and
cleaning the wafer using a composition containing ammonia and hydrogen peroxide.

The cleaning agent composition of the present invention comprises a specific nonionic surfactant and a quaternary ammonium hydroxide, so that this composition has excellent cleaning power against surface contamination of a semiconductor wafer such as silicon, gallium-arsenic, gallium-phosphorus and indium-phosphorus, electronics-related various glass substrates such as liquid crystal display glass substrate, solar cell glass substrate and crystal substrate, and a glass or ceramic-made precision work member requiring high cleanliness, such as lens for optical glasses, prism, optical fiber, quartz oscillator and polishing plate for semiconductor wafers.
Particularly, in the cleaning of a semiconductor wafer, the cleaning agent composition of the present invention exhibits excellent performance in both the degreasing and removal of particles on the wafer surface and can satisfactorily control the etching of the wafer cleaned.
Furthermore, by further containing an alkanolamine, the composition is more enhanced in the cleaning property and the life.
According to the method for cleaning a semiconductor wafer of the present invention, excellent performance can be exhibited in both the degreasing and removal of particles on the wafer surface and at the same time, the etching of the wafer cleaned can be satisfactorily controlled.
According to the method for producing a semiconductor wafer of the present invention, a semiconductor wafer extremely reduced in the particles attached to the wafer surface and remarkably reduced in the surface roughness can be obtained.
The semiconductor wafer obtained by the method of the present invention is extremely reduced in the particles attached to the wafer surface and remarkably reduced in the surface roughness.

BEST MODE FOR CARRYING OUT THE INVENTION

<Cleaning Agent Composition>

The essential components of the cleaning agent composition of the present invention are a nonionic surfactant of formula (I), a quaternary ammonium hydroxide, and an alkanolamine. The cleaning agent composition comprising these essential components can exhibit excellent cleaning power against the surface contamination of a semiconductor wafer and at the same time, can satisfactorily control the etching of the wafer.
In the nonionic surfactant of formula (I), $R^1$ is a linear or branched alkyl group having from 6 to 20 carbon atoms or a linear or branched alkenyl group having from 6 to 20 carbon atoms.
Specific examples of the alkyl group include a hexyl group, an isohexyl group, a methylpentyl group, a dimethylbutyl group, an ethylbutyl group, a heptyl group, a methylhexyl group, a propylbutyl group, a dimethylpentyl group, an octyl group, a nonyl group, a decyl group, a methylnonyl group, an ethyloctyl group, a dimethyloctyl group, an undecyl group, a dodecyl group, a tridecyl group, a tetradecyl group, a pentadecyl group, a heptadecyl and a nonadecyl group.
Specific examples of the alkenyl group include a hexenyl group, a methylpentenyl group, a decenyl group, an undecenyl group, a dodecenyl group, a tridecenyl group, a pentadecenyl group, a pentadecatrienyl group, a heptadecenyl group, a heptadecadienyl group and a nonadecenyl group.
The oxyethylene group (EO) is represented by $-CH_2-CH_2-O-$ and the oxypropylene group (PO) is represented by $-CH(CH_3)-CH_2-O-$ or $-CH_2-CH(CH_3)-O-$. EO and PO each is bonded by random addition or block addition and x number of EOs and y number of POs are arranged in an arbitrary order.

x and y each independently represents an integer of 1 to 20. Here, the value of x/ (x+y) must be 0.5 or more and when this value is 0.5 or more, a sufficiently high solubility in an aqueous alkali solution can be obtained. This value is preferably from 0.5 to less than 1.

Specific examples of the nonionic surfactant of formula (I) include a polyoxyethylene polyoxypropylene decanyl ether, a polyoxyethylene polyoxypropylene undecanyl ether, a polyoxyethylene polyoxypropylene dodecanyl ether and a polyoxyethylene polyoxypropylene tetradecanyl ether (those where x and y satisfy the above-described conditions). Among these surfactants, those where x=2 to 15, y=2 to 15 and R is a linear or branched alkyl group having from 8 to 18 carbon atoms or a linear or branched alkenyl group having from 8 to 18 carbon atoms are preferred.

The nonionic surfactant of formula (I) is contained in an amount of 0.0001 to 10 mass%, preferably from 0.0001 to 1 mass%, more preferably from 0.0001 to 0.5 mass%, based on the entire amount of the cleaning agent composition of the present invention. If the nonionic surfactant content exceeds 10 mass%, problems such as bubbling or rinsing are disadvantageously caused, whereas if the content is less than 0.0001 mass%, a sufficiently high effect cannot be obtained in the cleaning and prevention of etching.

In the present invention, the quaternary ammonium hydroxide used together with the nonionic surfactant of formula (I) is preferably a compound represented by formula (II).

In the quaternary ammonium hydroxide of formula (II), $R^2$, $R^3$, $R^4$ and $R^5$ may be the same or different and each independently represents an alkyl group having from 1 to 6 carbon atoms or a hydroxyalkyl group having from 1 to 6 carbon atoms.

Specific examples of the quaternary ammonium hydroxide of formula (II) include tetramethylammonium hydroxide (TMAH), trimethylhydroxyethylammonium hydroxide (choline), methyltrihydroxyethylammonium hydroxide, dimethyldihydroxyethylammonium hydroxide, tetraethylammonium hydroxide and trimethylethylammonium hydroxide. Among these, tetramethylammonium hydroxide and trimethylhydroxyethylammonium hydroxide are preferred. These quaternary ammonium hydroxides may be used individually, or two or more thereof may be used in combination at an arbitrary ratio.

The quaternary ammonium hydroxide is contained in an amount of 0.001 to 30 mass%, preferably from 0.05 to 20 mass%, based on the entire amount of the cleaning agent composition of the present invention. If the concentration of the quaternary ammonium hydroxide exceeds 30 mass%, the wafer is excessively etched and the etching cannot be controlled, giving rise to problems such as roughening of the wafer surface, whereas if the concentration is less than 0.001 mass%, a sufficiently high cleaning property cannot be maintained.

In addition to the nonionic surfactant of formula (I) and the quaternary ammonium hydroxide, the cleaning agent composition of the present invention further contains an alkanolamine. By containing an alkanolamine, the composition can be used as a cleaning agent enhanced in the cleaning property and in the life. The alkanolamine is preferably a compound represented by formula (III).

In the alkanolamine of formula (III), $R^6$ represents a hydroxyalkyl group having from 1 to 4 carbon atoms.

$R^7$ and $R^8$ may be the same of different and each independently represents a hydrogen atom, an alkyl group having from 1 to 4 carbon atoms, a hydroxyalkyl group having from 1 to 4 carbon atoms or an aminoalkyl group having from 1 to 4 carbon atoms. $R^7$ and $R^8$ may also combine to form an alkylene group having from 3 to 6 carbon atoms. The alkylene group may have an oxygen or nitrogen atom inserted between carbon atoms constituting the main chain, for example, between carbon atoms of a methylene group as in $-CH_2-O-CH_2-$ or $-CH_2-N-CH_2-$.

Specific examples of the alkanolamine of formula (III) include monoethanolamine, diethanolamine and triethanolamine. One of these alkanolamines may be used alone or two or more thereof may be used in combination at an arbitrary ratio.

The alkanolamine is contained in an amount of 0.001 to 50 mass%, preferably from 0.01 to 30 mass%, more preferably from 0.1 to 20 mass%, based on the entire amount of the cleaning agent composition of the present invention. If the concentration of alkanolamine exceeds 50 mass%, the cleaning performance disadvantageously decreases and this is also not preferred in view of profitability, whereas if the concentration is less than 0.001 mass%, the cleaning effect by the addition of an alkanolamine is not sufficiently high.

In the cleaning agent composition of the present invention, a surfactant other than the compound of formula (I) may be added so as to enhance the cleaning property. Examples of such a surfactant include a carboxylic acid represented by the following formula (IV):

$$R^9COOM \qquad (IV)$$

(wherein $R^9$ represents a linear or branched alkyl group having from 2 to 20 carbon atoms, where hydrogen atoms may be partially or entirely replaced by a fluorine atom, or a linear or branched alkenyl group having from 2 to 20 carbon atoms, where hydrogen atoms may be partially or entirely replaced by a fluorine atom, and M represents a hydrogen atom, an alkali metal atom, an ammonium group, an alkylammonium group or an alkanolammonium group) or a salt thereof;

a sulfonic acid represented by the following formula (V) :

$$R^{10}SO_3M \qquad (V)$$

(wherein $R^{10}$ represents a linear or branched alkyl group having from 2 to 20 carbon atoms, where hydrogen atoms may be partially or entirely replaced by a fluorine atom, or a linear or branched alkenyl group having from 2 to 20 carbon atoms, where hydrogen atoms may be partially or entirely replaced by a fluorine atom, and M represents a hydrogen atom, an alkali metal atom, an ammonium group, an alkylammonium group or an alkanolammonium group) or a salt thereof;
a polyoxyalkylene alkyl ether type represented by the following formula (VI):

$$R^{11}\text{-}O\text{-}(R^{12}\text{-}O)_p\text{-}H \qquad (VI)$$

(wherein $R^{11}$ represents a linear or branched alkyl group having from 6 to 20 carbon atoms, $R^{12}$ represents an alkylene group having from 2 to 4 carbon atoms, and p represents an integer of 3 to 20);
a polyoxyalkylene aryl ether type represented by the following formula (VII):

$$R^{13}\text{-}C_6H_4\text{-}O\text{-}(R^{14}\text{-}O)_q\text{-}H \qquad (VII)$$

(wherein $R^{13}$ represents a linear or branched alkyl group having from 6 to 20 carbon atoms, $R^{14}$ represents an alkylene group having from 2 to 4 carbon atoms, and q represents an integer of 3 to 20); and
a polyoxyalkylene alkyl ester type represented by the following formula (VIII):

$$R^{15}\text{-}COO\text{-}(R^{16}\text{-}O)_r\text{-}H \qquad (VIII)$$

(wherein $R^{15}$ represents a linear or branched alkyl group having from 9 to 16 carbon atoms, $R^{16}$ represents an alkylene group having from 2 to 4 carbon atoms, and r represents an integer of 6 to 16).

In some cases, use of a fluorine-containing anionic surfactant is particularly effective. Specific examples of the fluorine-containing anionic surfactant include perfluoroheptanoic acid ($C_6F_{13}COOH$), perfluorocaprylic acid ($C_7F_{15}COOH$), perfluorononanoic acid ($C_8F_{17}COOH$), 5, 5, 6, 6, 7, 7, 8, 8, 9, 9, 9-undecafluorononanoic acid ($C_5F_{11}(CH_2)_3COOH$), perfluorocapric acid ($C_9F_{19}COOH$), perfluorododecanoic acid ($C_{11}F_{23}COOH$), 6,6,7,7,8,8,9,9,10,10,11,11,12,12,12-pentadecafluoro-4-dodecenoic acid ($CF_3(CF_2)_6CH{=}CH(CH_2)_2COOH$), perfluorotetradecanoic acid ($C_{13}F_{27}COOH$), 12-trifluoromethyl-12,13,13,14,14,15,15,16,16,16-decafluorohexadecanoic acid ($CF_3(CF_2)_3CF(CF_3)(CH_2)_{10}COOH$), perfluorooctanesulfonic acid ($C_8F_{17}SO_3H$), and ammonium salts and tetramethylammonium salts thereof.

These surfactants other than the compound represented by formula (I) may be used individually or two or more thereof may be used in combination at an arbitrary ratio.

This surfactant is contained in an amount of 0.0001 to 5 mass%, preferably from 0.0001 to 1 mass%, more preferably from 0.0001 to 0.5 mass%, based on the entire amount of the cleaning agent composition of the present invention. If the content exceeds 5 mass%, problems such as bubbling or rinsing may disadvantageously arise, whereas if the content is less than 0.0001 mass%, the activity of enhancing the cleaning power cannot be satisfactorily brought out.

In the cleaning agent composition of the present invention, hydrogen peroxide can be added. In the case of cleaning a silicon wafer, the etching of wafer can be prevented by the addition of only a surfactant to the aqueous alkali solution. However, this effect is greatly affected by the kind of surfactant, the alkali concentration, the temperature and the like and a sufficiently high effect is not always obtained in all possible conditions. By using hydrogen peroxide, the etching on the wafer surface can be appropriately controlled even at high temperatures (for example, from 60 to 80°C) and the cleaning agent composition of the present invention can be broadened in the range of use.

In the case of adding hydrogen peroxide, the hydrogen peroxide may be added in the range from 0.01 to 20 mass%, preferably from 0.05 to 10 mass%, based on the entire amount of the cleaning agent composition. If the hydrogen peroxide concentration exceeds 20 mass%, the amount of hydrogen peroxide decomposed increases and this is not profitable, though the cleaning power itself is not particularly affected. On the other hand, if the concentration is less than 0.01 mass%, a sufficiently high effect of preventing etching cannot be obtained.

In the cleaning agent composition of the present invention, a complexing agent may be further added so as to enhance the cleaning power for metal ion. Specific examples of the complexing agent include ethylenediaminetetraacetic acid, diethylenetriaminepentaacetic acid, citric acid, gluconic acid, oxalic acid, tartaric acid and aleic acid. In the case of adding a complexing agent, the complexing agent can be added in an arbitrary amount within the range where the etching of wafer does not proceed.

The cleaning agent composition of the present invention exhibits an excellent cleaning effect at ordinary temperature and this composition can also be used for the cleaning under appropriate heating or for the cleaning using ultrasonic wave.

The cleaning agent composition of the present invention exhibits high contamination-removing performance and enables effective surface cleaning in a relatively short time not only when used for the cleaning of a semiconductor wafer but also when used for the surface cleaning of electronics-related various glass substrates such as liquid crystal display glass substrate, solar cell glass substrate and crystal substrate, or for the surface cleaning of a glass or ceramic-made precision work member requiring high cleanliness, such as lens for optical glasses, prism, optical fiber, quartz oscillator and polishing plate for semiconductor wafers.

<Method for Cleaning Semiconductor Wafer>

The method for cleaning a semiconductor wafer of the present invention comprises:

(i) cleaning the wafer using the above-described cleaning agent composition; and
(ii) cleaning the wafer using a cleaning agent containing ammonia and hydrogen peroxide.

The cleaning step (i) is a step provided mainly for performing the degreasing and removal of particles on the semiconductor wafer surface.

The cleaning step (ii) is a step provided mainly for performing the removal of particles on the semiconductor wafer surface.

Examples of the semiconductor wafer which can be cleaned by using the cleaning method of the present invention include one-element semiconductor wafers such as silicon and germanium, and compound semiconductor wafers such as gallium-phosphorus, gallium-arsenic and indium-phosphorus.

Representative examples of the step for performing the degreasing and removal of particles on the semiconductor wafer surface include wax cleaning after specular polishing of a wafer. The specular polishing of a semiconductor wafer is performed by bonding/fixing the wafer to a plate (jig) with a wax. Therefore, when the wafer is stripped off from the plate after the completion of polishing, a large amount of wax used as an adhesive remains adhering to the wafer. The above-described cleaning agent composition of the present invention is particularly effective for the cleaning to remove the wax and particles adhering to the wafer and this composition is used in the cleaning step (i).

The cleaning agent composition of the present invention provides both a wax-removing effect and a particle-removing effect even when used by itself, but when used in combination with other cleaning agent, more effective cleaning can be attained. One embodiment of this cleaning method of the present invention is described below.

First, cleaning for removing wax and particles is performed by using the cleaning agent composition of the present invention comprising a nonionic surfactant of formula (I) [$R^1O(EO)_x(PO)_yH$], TMAH and an alkanolamine. In this cleaning agent, hydrogen peroxide may be added, if desired.

Then, cleaning for removing particles is performed by using a cleaning agent containing aqueous ammonia and aqueous hydrogen peroxide.

Each cleaning step may be performed multiple times or a rinsing step of using, for example, water may also be performed. After the completion of all cleaning steps, the wafer is dried by using an organic solvent such as isopropyl alcohol. On the thus-dried semiconductor wafer, not only wax is removed but also good particle level is attained and at the same time, the wafer surface is less etched as compared with the case of using a conventional cleaning solution.

Those two cleaning steps each is not particularly limited in the cleaning temperature, cleaning conditions and the like, and proper conditions can be appropriately selected according to the wafer to be cleaned.

For example, the cleaning is specifically performed by a method of subjecting a cleaning agent composition having dipped therein a wafer to be cleaned, to filtration and circulation through an appropriate filter for removal of particles, so that particles in the solution can be removed. In this case, when the cleaning agent composition of the present invention is used, the number of particles in the cleaning agent solution can be always maintained to a low level and in turn the amount of particles re-adsorbed to the wafer surface can be decreased, as a result, cleaning with excellent particle-removing performance can be performed.

<Method for Producing Semiconductor Wafer>

The method for producing a semiconductor wafer of the present invention is described below. In the following, the method for producing a silicone wafer, which is one embodiment of the production method of the present invention, is described, however, the present invention is not limited only to the production method of a silicon wafer but can be also applied, for example, to a wafer of one-element semiconductor such as germanium or compound semiconductor such as gallium-arsenic, gallium-phosphorus and indium-phosphorus.

The method for producing a semiconductor wafer of the present invention comprises:

lapping the water surface;
specularly polishing the wafer surface;
cleaning the wafer using the above-described cleaning agent composition of the present invention; and
cleaning the wafer using a composition containing ammonia and hydrogen peroxide.

As a previous step of these steps, a silicon single crystal is withdrawn and the withdrawn ingot is passed through circumferential grinding and orientation flatting and then sliced into a wafer shape. The produced wafer is passed through a beveling (side polishing) step and a lapping (surface polishing) step, and then transferred to a polishing (specular polishing) step.

The specular polishing of wafer is performed by bonding/fixing the wafer to a glass- or ceramic-made plate (jig) with a wax (adhesive) and polishing the wafer surface with an abrasive and an abrasive cloth. After the completion of specular polishing, the wafer is stripped off from the plate and transferred to the cleaning steps to remove wax or particles adhering to the wafer or remove contamination such as metal impurities.

This cleaning step is the same as in the above-described cleaning method of the present invention and comprises a cleaning step of using the cleaning agent composition of the present invention and a cleaning step of using a composition containing ammonia and hydrogen peroxide.

After the completion of cleaning, the wafer surface is inspected and a product semiconductor wafer is obtained.

According to this production method, a semiconductor wafer extremely reduced in particles adhering to the semiconductor wafer surface and in the surface roughening can be obtained.

For example, a semiconductor wafer where the number of particles adhering to the wafer surface and having a particle size of 0.2 μm or more is 130 or less per 100 $cm^2$ of the wafer surface can be obtained.

When the particles are counted without limitation of the wafer size, a semiconductor wafer where the number of particles adhering to the wafer surface and having a particle size of 0.2 μm or more is 100 or less per one sheet of wafer (for example, 4-inch size) can be obtained.

In the case where a silicon wafer is used as the wafer, a semiconductor wafer having a surface roughness (Ra) of 0.2 nm or less is obtained.

In the case where a gallium-arsenic wafer is used as the wafer, a semiconductor wafer having a surface roughness (Ra) of 0.4 nm or less is obtained.

Here, Ra is determined by applying a calculation described in JIS B 0601 "1994: Hyomen Arasa - Teigi oyobi Hyoji (Surface Roughness - Definition and Indication)", to the roughness curve obtained by scanning the wafer surface with an atomic force microscope. More specifically, just a standard length is extracted from the roughness curve in the direction of its average line, the average line direction and the longitudinal magnification direction in this extracted portion are taken as X-axis and Y-axis, respectively, and when the roughness curve is represented by y=f(x), Ra is a value obtained according to the following equation and expressed by nanometer:

$$Ra = \frac{1}{l}\int_0^l |f(x)|dx$$

(wherein *l* represents a standard length).

EXAMPLES

The present invention is described in greater detail below by referring to Examples and Comparative Examples, however, the present invention is not limited to these Examples.

[Etching Rate]

Cleaning agent compositions of Examples 1 and 2 and Comparative Examples 1 to 5 were prepared by adding water to the blending components shown in Table 1 to make 100 wt%. Each composition was measured on the etching rate for a silicon wafer.

The measurement was performed by the following method. A P-type (100) single crystal silicon wafer was treated with dilute hydrofluoric acid to remove the natural oxide film and then dipped in each cleaning agent composition for 70 hours. From the change in the weight of wafer between before and after the dipping, the total etching rate on the entire surface (front surface, back surface, side surfaces) of wafer was calculated.

The results obtained are shown in Table 1.

[Table 1]

| | | Example | | Comparative Example | | | | |
|---|---|---|---|---|---|---|---|---|
| | | 1* | 2* | 1 | 2 | 3 | 4 | 5 |
| Blending Components (wt%) | TMAH | 0.08 | 0.08 | 0.08 | 0.08 | 0.08 | 0.08 | 0.08 |
| | Nonionic Surfactant (1)-1 | 0.1 | | | | | | |
| | Nonionic Surfactant (1)-2 | | 0.1 | | | | | |
| | Nonionic Surfactant (2)-1 | | | 0.1 | | | | |
| | Nonionic Surfactant (2)-2 | | | | 0.1 | | | |
| | Nonionic Surfactant (2)-3 | | | | | 0.1 | | |
| | Nonionic Surfactant (3)-1 | | | | | | 0.1 | |
| | Nonionic Surfactant (4)-1 | | | | | | | 0.1 |
| Etching rate (Å/min) | | 3.0 | 2.6 | 3.3 | 4.3 | 4.8 | 6.4 | 3.4 |

TMAH: Tetramethylammonium hydroxide
* not belonging to the scope of the present invention
Nonionic Surfactant (1)-1:
$C_nH_{2n+1}$-O-$(CH_2CH_2O)_x(CH_2CH(CH_3)O)_yH$ (n=11, x=6, y=2)
Nonionic Surfactant (1)-2:
$C_nH_{2n+1}$-O-$(CH_2CH_2O)_x(CH_2CH_2O)_x(CH_3)OH$ (n=11, x=8 , y=7)
Nonionic Surfactant (2)-1:
Polyoxyethylene nonylphenyl ether (ethylene oxide addition molar number: 10)
Nonionic Surfactant (2)-2:
Polyoxyethylene nonylphenyl ether (ethylene oxide addition molar number: 15)
Nonionic Surfactant (2)-3:
Polyoxyethylene nonylphenyl ether (ethylene oxide addition molar number: 20)
Nonionic Surfactant (3)-1:
Pluronic type (polypropylene glycol molecular weight: 2,250, ethylene oxide content: 40 wt%)
Nonionic Surfactant (4)-1:
Polyoxyethylene alkyl ether (HLB: 14.5)

As apparent from the results in Table 1, the cleaning agent compositions of Examples 1 and 2 where the nonionic surfactant of formula (I) is used in combination with a quaternary ammonium hydroxide show a low etching rate on the silicon wafer and accordingly, the wafer surface is less damaged by the cleaning.

On the other hand, in Comparative Examples 1 to 5 where a compound other than the specific structure of formula (I) is used, even if the compound is a polyoxyalkylene-base nonionic surfactant, the etching rate on the silicon wafer is high and therefore, the damage of the wafer surface is large as compared with Examples 1 and 2.

As verified above, by using the nonionic surfactant of formula (I) in combination with a quaternary ammonium hydroxide, the etching rate can be satisfactorily controlled.

[Removability of Wax Contamination]

A commercially available wax (Alfa-Liquid TR-100, trade name, produced by Intec) was coated to a thickness of 1.7 μm on a 6-inch P-type (100) single crystal silicon wafer surface and then baked at 80˚C for 5 minutes to produce a test wafer.

Cleaning agent compositions of Examples 3 and 4 and Comparative Example 6 were prepared by adding water to the blending components shown in Table 2 to make 100 wt% and the test wafer was dipped in each cleaning agent composition at 25°C for 6 minutes. Thereafter, the test wafer was rinsed with ultrapure water for 6 minutes and then dried. A light-gathering lamp was applied on the treated wafer surface and the wax removability was evaluated with a naked eye according to the following criteria.

Criteria:

○: Wax was completely removed.
Δ: Wax partially remained.
×: Wax remained over the entire surface of wafer.

The evaluation results are shown in Table 2.

[Table 2]

| | | Example | Example | Comparative Example |
|---|---|---|---|---|
| | | 3 | 4 | 6 |
| Blending Components (wt%) | TMAH | 0.1 | 0.1 | 0.1 |
| | Monoethanolamine | 0.1 | 0.1 | |
| | Isopropyl alcohol | | | 0.6 |
| | Nonionic Surfactant (1)-1 | 0.1 | 0.1 | |
| | Nonionic Surfactant (4)-2 | | | 0.1 |
| | Anionic Surfactant (1) | | 0.1 | |
| Wax removability | | ○ | ○ | Δ |
| Nonionic Surfactant (4)-2:<br>Pluronic type (ADEKA L61) (polypropylene glycol molecular weight: 1,750, ethylene oxide content: 10 wt%)<br>Anionic Surfactant (1) : $C\text{-}_7F_{15}COOH$ | | | | |

As apparent from the results in Table 2, when treated with the cleaning agent compositions of Examples 3 and 4 where the nonionic surfactant of formula (I) is used in combination with a quaternary ammonium hydroxide, the wax on the wafer surface is completely removed at the observation with a naked eye and these compositions have excellent wax removability.

On the other hand, in Comparative Example 6 where a compound other than the specific structure of formula (I) is used, the wax remains on the wafer surface at the observation with a naked eye and the wax removability is insufficient.

In this way, by using the nonionic surfactant of formula (I) in combination with a quaternary ammonium hydroxide, an excellent result is obtained also in the wax removability.

[Filterability of Particle]

In a polyethylene-made container, 20 L of each cleaning agent composition of Example 5 and Comparative Example 7 was produced by adding water to the blending components shown in Table 3 to make 100 wt%.

Each cleaning agent composition was filtered and circulated at a rate of 2 L/min through a 0.05-μm Teflon(R) filter to remove particles in the solution. The number of particles was measured at the preparation of solution and after filtration and circulation for 10 minutes. For the measurement of the number of particles, an in-liquid particle counter KL-20 manufactured by Rion Co., Ltd. was used.

The measurement results are shown in Table 3.

[Table 3]

| | | Example* | Comparative Example |
|---|---|---|---|
| | | 5 | 7 |
| Blending Components (wt%) | TMAH | 2.5 | 2.5 |
| | Nonionic Surfactant (1)-1 | 0.5 | |
| | Nonionic Surfactant (2)-1 | | 0.5 |
| Number of Number of Particles (0.2 μm, /ml) | At the preparation of solution (before filtration/circulation) | 4579 | 2908 |
| | filtration/circulation After for 10 minutes | 240 | 2683 |
| * not belonging to the scope of the present invention | | | |

As apparent from the results in Table 3, the cleaning agent composition of Example 5 where the nonionic surfactant of formula (I) is used in combination with a quaternary ammonium hydroxide is remarkably excellent in the filterability of particles as compared with the cleaning agent composition of Comparative Example 7 where a compound other than the specific structure of formula (I) is used.

In this way, by using the nonionic surfactant of formula (I) in combination with a quaternary ammonium hydroxide, excellent filterability of particles can be obtained.

Furthermore, when circulation through a filter is performed at the cleaning of wafer, the number of particles in the solution can be always maintained to a very low level, as a result, the amount of particles re-adsorbed to the wafer surface can be reduced.

[Solubility of Surfactant in Aqueous Alkali Solution]

Cleaning agent compositions of Examples 6 to 8 and Comparative Example 8 each was prepared from the blending components shown in Table 4 and water by adding the surfactant to an aqueous alkali solution prepared by dissolving TMAH in water, to make a total of 100 wt%. At the preparation, whether the solution became turbid on adding the surfactant to the aqueous alkali solution was observed with a naked dye, thereby evaluating the solubility of surfactant. The evaluation was performed according to the following criteria:

Criteria:

○: The solution did not become turbid and remained colorless and transparent.
×: The solution became turbid.

The evaluation results are shown in Table 4.

[Table 4]

| | | | Example* | | | Comparative Example |
|---|---|---|---|---|---|---|
| | | x/(x+y) | 6 | 7 | 8 | 8 |
| Blending Components (wt%) | TMAH | - | 0.1 | 0.1 | 0.1 | 0.1 |
| | Nonionic Surfactant (1) -3 | 0.37 | | | | 0.1 |
| | Nonionic Surfactant (1)-2 | 0.53 | 0.1 | | | |
| | Nonionic Surfactant (1)-1 | 0.75 | | 0.1 | | |
| | Nonionic Surfactant (1)-4 | 0.83 | | | 0.1 | |

(continued)

| | | Example* | | | Comparative Example |
|---|---|---|---|---|---|
| | x/(x+y) | 6 | 7 | 8 | 8 |
| Solubility | | ○ | ○ | ○ | × |

* not belonging to the scope of the present invention
Nonionic Surfactant (1)-3:
$C_nH_{2n+1}$-O-$(CH_2CH_2O)_x(CH_2CH(CH_3)O_yH$ (n=13, x=6, y=10)
Nonionic Surfactant (1)-4:
$C_nH_{2n+1}$-O-$(CH_2CH_2O)_x(CH_2CH(CH_3)O)_yH$ (n=13, x=10, y=2)

As apparent from the results in Table 4, in Examples 6 to 8 where the nonionic surfactant of formula (I) has an x/(x+y) value of 0.5 or more, the solubility in an aqueous alkali solution is good.

On the other hand, in Comparative Example 8 where the x/(x+y) value is less than 0.5, the solubility of surfactant in an aqueous alkali solution decreases. In such a case, another compound such as a water-soluble organic compound (for example, isopropyl alcohol) must be added so as to elevate the solubility of surfactant.

## Claims

**1.** A cleaning agent composition comprising a nonionic surfactant represented by the following formula (I):

$$R^1O(EO)_x(PO)_yH \qquad (I)$$

(wherein $R^1$ represents a linear or branched alkyl group having from 6 to 20 carbon atoms or a linear or branched alkenyl group having from 6 to 20 carbon atoms, EO represents an oxyethylene group, PO represents an oxypropylene group, EO and PO each is bonded by random addition or block addition, x number of EOs and y number of POs are arranged in an arbitrary order, x and y each independently represents an integer of 1 to 20, and x/ (x+y) is 0.5 or more), a quaternary ammonium hydroxide, and an alkanolamine.

**2.** The cleaning agent composition as claimed in Claim 1, wherein the quaternary ammonium hydroxide is a compound represented by the following formula (II):

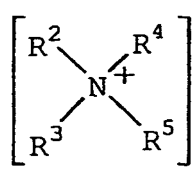

$OH^-$ (II)

(wherein $R^2$, $R^3$, $R^4$ and $R^5$ each independently represents an alkyl group having from 1 to 6 carbon atoms or a hydroxyalkyl group having from 1 to 6 carbon atoms).

**3.** The cleaning agent composition as claimed in Claim 2, wherein the quaternary ammonium hydroxide is tetramethylammonium hydroxide.

**4.** The cleaning agent composition as claimed in Claim 1, wherein the alkanolamine is a compound represented by the following formula (III):

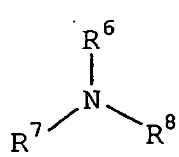

(III)

(wherein $R^6$ represents a hydroxyalkyl group having from 1 to 4 carbon atoms; and $R^7$ and $R^8$ each independently represents a hydrogen atom, an alkyl group having from 1 to 4 carbon atoms, a hydroxyalkyl group having from 1 to 4 carbon atoms or an aminoalkyl group having from 1 to 4 carbon atoms, or $R^7$ and $R^8$ combine to form an alkylene group having from 3 to 6 carbon atoms, and the alkylene group may have an oxygen or nitrogen atom inserted between carbon atoms constituting the main chain).

**5.** The cleaning agent composition as claimed in Claim 4, wherein the alkanolamine is any one compound selected from the group consisting of monoethanolamine, diethanolamine and triethanolamine.

**6.** The cleaning agent composition as claimed in any one of Claims 1 to 5, wherein the alkanolamine is contained in an amount of 0.001 to 50 mass% based on the entire amount of the cleaning agent composition.

**7.** The cleaning agent composition as claimed in any one of Claims 1 to 6, wherein the nonionic surfactant is contained in an amount of 0.0001 to 10 mass% based on the entire amount of the cleaning agent composition.

**8.** The cleaning agent composition as claimed in any one of Claims 1 to 7, wherein the quaternary ammonium hydroxide is contained in an amount of 0.001 to 30 mass% based on the entire amount of the cleaning agent composition.

**9.** A method for cleaning a semiconductor wafer, comprising the steps of:

(i) cleaning the wafer using the cleaning agent composition as claimed in any one of Claims 1 to 8; and
(ii) cleaning the wafer using a composition containing ammonia and hydrogen peroxide.

**10.** The method for cleaning a semiconductor wafer as claimed in Claim 9, wherein the degreasing and removal of particles on the semiconductor wafer surface are performed in the step (i).

**11.** The method for cleaning a semiconductor wafer as claimed in Claim 10, wherein the removal of particles on the semiconductor wafer surface are performed in the step (ii).

**12.** A method for producing a semiconductor wafer, comprising the steps of:

lapping the wafer surface;
specularly polishing the wafer surface;
cleaning the wafer using the cleaning agent composition as claimed in any one of Claims 1 to 8; and
cleaning the wafer using a composition containing ammonia and hydrogen peroxide.

## Patentansprüche

**1.** Reinigungsmittelzusammensetzung, die ein nichtionisches oberflächenaktives Mittel der folgenden Formel (I):

$$R^1O(EO)_x(PO)_yH \qquad (I)$$

(worin $R^1$ eine lineare oder verzweigte Alylgruppe mit 6 bis 20 Kohlenstoffatomen oder eine lineare oder verzweigte Alkenylgruppe mit 6 bis 20 Kohlenstoffatomen darstellt, EO eine Oxyethylengruppe darstellt, PO eine Oxypropylengruppe darstellt, EO und PO jeweils durch statistische Addition oder Blockaddition gebunden sind, eine Anzahl x der EOs und eine Anzahl y der POs in statistischer Reihenfolge angeordnet sind, x und y jeweils unabhängig voneinander eine ganze Zahl von 1 bis 20 darstellen und x/(x+y) 0,5 oder mehr ist), ein quartäres Ammoniumhydroxid und ein Alkanolamin umfaßt.

**2.** Reinigungsmittelzusammensetzung nach Anspruch 1, wobei das quartäre Ammoniumhydroxid eine Verbindung der folgenden Formel (II) ist:

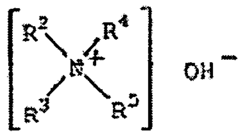 (II)

(worin $R^2$, $R^3$, $R^4$ und $R^5$ jeweils unabhängig voneinander eine Alkylgruppe mit 1 bis 6 Kohlenstoffatomen oder eine Hydroxyalkylgruppe mit 1 bis 6 Kohlenstoffatomen darstellen).

**3.** Reinigungsmittelzusammensetzung nach Anspruch 2, worin das quartäre Ammoniumhydroxid Tetramethylammoniumhydroxid ist.

**4.** Reinigungsmittelzusammensetzung nach Anspruch 1, worin das Alkanolamin eine Verbindung der folgenden Formel (III) ist:

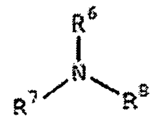 (III)

(worin $R^6$ eine Hydroxyalkylgruppe mit 1 bis 4 Kohlenstoffatomen darstellt; und $R^7$ und $R^8$ jeweils unabhängig voneinander ein Wasserstoffatom, eine Alkylgruppe mit 1 bis 4 Kohlenstoffatomen, eine Hydroxyalkylgruppe mit 1 bis 4 Kohlenstoffatomen oder eine Aminoalkylgruppe mit 1 bis 4 Kohlenstoffatomen darstellen, oder $R^7$ und $R^8$ unter Bildung einer Alkylengruppe mit 3 bis 6 Kohlenstoffatomen kombinieren, wobei die Alkylengruppe ein Sauerstoffatom oder ein Stickstoffatom zwischen den Kohlenstoffatomen, welche die Hauptkette bilden, eingefügt aufweisen kann).

**5.** Reinigungsmittelzusammensetzung nach Anspruch 4, worin das Alkanolamin eine Verbindung ist, die aus der Gruppe ausgewählt ist, die aus Monoethanolamin, Diethanolamin und Triethanolamin besteht.

**6.** Reinigungsmittelzusammensetzung nach einem der Ansprüche 1 bis 5, worin das Alkanolamin in einer Menge von 0,001 bis 50 Massen-%, bezogen auf die Gesamtmenge der Reinigungsmittelzusammensetzung, enthalten ist.

**7.** Reinigungsmittelzusammensetzung nach einem der Ansprüche 1 bis 6, worin das nicht-ionische oberflächenaktive Mittel in einer Menge von 0,0001 bis 10 Massen-%, bezogen auf die Gesamtmenge der Reinigungsmittelzusammensetzung, enthalten ist.

**8.** Reinigungsmittelzusammensetzung nach einem der Ansprüche 1 bis 7, worin das quartäre Ammoniumhydroxid in einer Menge von 0,001 bis 30 Massen-%, bezogen auf die Gesamtmenge der Reinigungsmittelzusammensetzung, enthalten ist.

**9.** Verfahren zum Reinigen eines Halbleiterwafers, welches die folgenden Stufen umfaßt:

(i) Reinigen des Wafers unter Verwendung der Reinigungsmittelzusammensetzung nach einem der Ansprüche 1 bis 8; und
(ii) Reinigen des Wafers unter Verwendung einer Zusammensetzung, die Ammoniak und Wasserstoffperoxid enthält.

**10.** Verfahren zum Reinigen eines Halbleiterwafers nach Anspruch 9, wobei das Entfetten und das Entfernen von Teilchen auf der Halbleiterwaferoberfläche in Stufe (i) durchgeführt wird.

**11.** Verfahren zum Reinigen eines Halbleiterwafers nach Anspruch 10, wobei das Entfernen von Teilchen auf der Halbleiterwaferoberfläche in Stufe (ii) durchgeführt wird.

**12.** Verfahren zum Herstellen eines Halbleiterwafers, welches die folgenden Stufen umfaßt:

Feinschleifen der Waferoberfläche;
Spiegelpolieren der Waferoberfläche;
Reinigen des Wafers unter Verwendung der Reinigungsmittelzusammensetzung nach einem der Ansprüche 1 bis 8; und
Reinigen des Wafers unter Verwendung einer Zusammensetzung, die Ammoniak und Wasserstoffperoxid enthält.

**Revendications**

1. Composition d'agent de nettoyage comprenant un agent tensioactif non ionique représenté par la formule (I) suivante :

$$R^1O(EO)_x(PO)_yH \qquad (I)$$

(dans laquelle $R^1$ représente un groupe alkyle linéaire ou ramifié comportant 6 à 20 atomes de carbone ou un groupe alcényle linéaire ou ramifié comportant 6 à 20 atomes de carbone, EO représente un groupe oxyéthylène, PO représente un groupe oxypropylène, EO et PO sont chacun liés par addition aléatoire ou addition séquencée, le nombre x de EO et le nombre y de PO sont agencés selon un ordre arbitraire, x et y représentent chacun indépendamment un entier de 1 à 20, et x/(x+y) vaut 0,5 ou plus), un hydroxyde d'ammonium quaternaire et une alcanolamine.

2. Composition d'agent de nettoyage selon la revendication 1, dans laquelle l'hydroxyde d'ammonium quaternaire est un composé représenté par la formule (II) suivante :

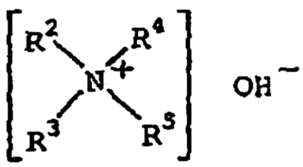 (II)

(dans laquelle $R^2$, $R^3$, $R^4$ et $R^5$ représentent chacun indépendamment un groupe alkyle comportant 1 à 6 atomes de carbone ou un groupe hydroxyalkyle comportant 1 à 6 atomes de carbone).

3. Composition d'agent de nettoyage selon la revendication 2, dans laquelle l'hydroxyde d'ammonium quaternaire est l'hydroxyde de tétraméthylammonium.

4. Composition d'agent de nettoyage selon la revendication 1, dans laquelle l'alcanolamine est un composé représenté par la formule (III) suivante :

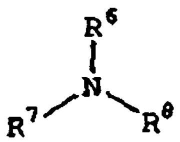 (III)

(dans laquelle $R^6$ représente un groupe hydroxyalkyle comportant 1 à 4 atomes de carbone ; et $R^7$ et $R^8$ représentent chacun indépendamment un atome d'hydrogène, un groupe alkyle comportant 1 à 4 atomes de carbone, un groupe hydroxyalkyle comportant 1 à 4 atomes de carbone ou un groupe aminoalkyle comportant 1 à 4 atomes de carbone, ou $R^7$ et $R^8$ se combinent pour former un groupe alkylène comportant 3 à 6 atomes de carbone, et le groupe alkylène peut comportant un atome d'oxygène ou d'azote inséré entre les atomes de carbone constituant la chaîne principale).

5. Composition d'agent de nettoyage selon la revendication 4, dans laquelle l'alcanolamine est n'importe quel composé

choisi dans le groupe constitué par la monoéthanolamine, la diéthanolamine et la triéthanolamine.

**6.** Composition d'agent de nettoyage selon l'une quelconque des revendications 1 à 5, dans laquelle l'alcanolamine est contenue en une quantité de 0,001 à 50 % en masse sur la base de la quantité entière de la composition d'agent de nettoyage.

**7.** Composition d'agent de nettoyage selon l'une quelconque des revendications 1 à 6, dans laquelle l'agent tensioactif non ionique est contenu en une quantité de 0,0001 à 10 % en masse sur la base de la quantité entière de la composition d'agent de nettoyage.

**8.** Composition d'agent de nettoyage selon l'une quelconque des revendications 1 à 7, dans laquelle l'hydroxyde d'ammonium quaternaire est contenu en une quantité de 0,001 à 30 % en masse sur la base de la quantité entière de la composition d'agent de nettoyage.

**9.** Procédé de nettoyage d'une tranche de semi-conducteur comprenant les étapes consistant à:

(i) nettoyer la tranche en utilisant la composition d'agent de nettoyage selon l'une quelconque des revendications 1 à 8 ; et
(ii) nettoyer la tranche en utilisant une composition contenant de l'ammoniac et du peroxyde d'hydrogène.

**10.** Procédé de nettoyage d'une tranche de semi-conducteur selon la revendication 9, dans lequel le dégraissage et l'élimination de particules sur la surface de la tranche de semi-conducteur sont effectués à l'étape (i).

**11.** Procédé de nettoyage d'une tranche de semi-conducteur selon la revendication 10, dans lequel l'élimination de particules sur la surface de la tranche de semi-conducteur est effectuée à l'étape (ii).

**12.** Procédé de production d'une tranche de semi-conducteur comprenant les étapes consistant à:

roder la surface de la tranche ;
polir de manière spéculaire la surface de la tranche ;
nettoyer la tranche en utilisant la composition d'agent de nettoyage selon l'une quelconque des revendications 1 à 8 ; et
nettoyer la tranche en utilisant une composition contenant de l'ammoniac et du peroxyde d'hydrogène.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 50147287 A
- JP 2579401 B
- JP 2001214199 A